# DEMANDE DE BREVET EUROPEEN

(11) **EP 2 091 147 A1**
(43) Date de publication de la demande: **19.08.2009**
(21) Numéro de dépôt: 09368004.9
(22) Date de dépôt: 13.02.2009
(51) Int. Cl.: H03H 9/58

(54) **Circuit de filtrage comportant des résonateurs acoustiques couplés**

(30) Priorité: 15.02.2008 FR 0800828
(71) Demandeur: STMicroelectronics SA, 92120 Montrouge (FR); Centre National de la Recherche Scientifique (C.N.R.S.), 75794 Paris (FR)
(72) Inventeur: Cathelin, Andrea, 38190 Laval (FR); Belot, Didier, 38140 Rives (FR); Shirakawa, Alexandre Augusto, 33405 Talence (FR); Pham, Jean-Marie, 33700 Merignac (FR); Kerherve, Eric, 33400 Talence (FR); Jarry, Pierre, 33400 Talence (FR)
(74) Mandataire: Schuffenecker, Thierry

(57) **Abrégé**

Filtre à résonateur couplés comportant :
- un substrat (100) ;
- un miroir acoustique (101) destiné à servir de support à des résonateurs acoustiques , et à isoler ces résonateurs du substrat ;
- une première structure (GAUCHE) comportant un résonateur supérieur (120) et un résonateur inférieur (110) couplés l'un à l'autre au moyen d'au moins une couche de couplage acoustique (130) ;
- une seconde structure (DROITE) comportant un résonateur supérieur (220) et un résonateur inférieur (210) couplés l'un à l'autre au moyen d'au moins une couche de couplage acoustique (130) ;
- lesdits résonateurs inférieurs de la première et seconde structure disposant des mêmes électrodes (211, 213).

Le filtre est **caractérisé en ce que** les première et seconde structures sont connectées via un cinquième résonateur (300) dont les électrodes et la couche piézo-électriques sont celles desdits résonateurs inférieurs de la dite première et seconde structure.

## Description

### Domaine technique de l'invention

La présente invention concerne les circuits électroniques et notamment un circuit de filtrage comportant des résonateurs acoustiques couplés.

### Etat de la technique

Les résonateurs acoustiques sont aujourd'hui très répandus dans les applications grand-public mais également dans les applications professionnelles en raison de leur grande efficacité et ce notamment pour la réalisation de filtres passe-bandes très performants en téléphonie mobile.

Les recherches ont porté sur deux types de résonateurs acoustiques qui présentent des performances remarquables, à savoir les résonateurs de type SAW (*Surface Acoustic Resonator*) et, plus récemment, ceux de type BAW (*Bulk Acoustic Resonator*). Dans les premiers, le résonateur acoustique est situé sur la surface d'un produit semiconducteur tandis que, dans les seconds, il est disposé à l'intérieur d'un volume délimité entre une électrode inférieure et une électrode supérieure en sorte que l'onde acoustique se développe dans ce même volume. Les résonateurs de type BAW font l'objet d'intenses recherches par les fabricants de produits semi-conducteurs car ces composants permettent d'envisager une intégration très poussée des circuits de filtrage et, par conséquent, laissent entrevoir une baisse significative du coût de fabrication de ces mêmes circuits.

Les résonateurs de type BAW permettent d'envisager des fréquences plus élevées que celles mises en oeuvres par les SAW, tout en offrant un encombrement particulièrement réduit.

De manière classique on regroupe des résonateurs de type BAW de manière à constituer des structures plus complexes, de type « échelle » ou « maille » permettant de réaliser des filtres passe-bande très performants.

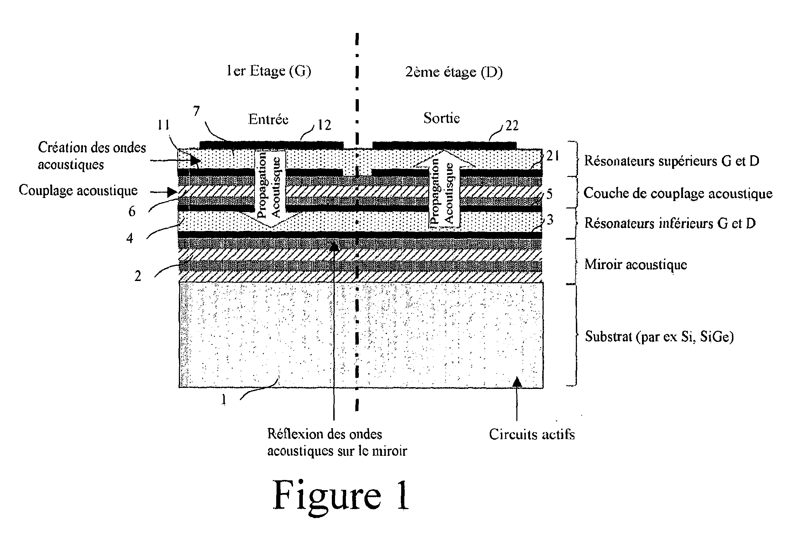

Un autre groupement connu consiste à réaliser un couplage entre plusieurs résonateurs afin de réaliser un ensemble plus complexe. On connaît ainsi un filtre à résonateurs couplés - ou CRF de l'appellation anglo-saxonne *Coupled Resonator Filter*-qui est particulièrement illustré dans la figure 1.

Ce circuit comporte, comme on le voit dans la figure, deux structures ou étages parfaitement symétriques par rapport à un axe vertical passant par le milieu de la figure.

Un premier étage se compose d'un résonateur supérieur comportant deux électrodes respectivement inférieure 11 et supérieure 12 enserrant une couche de matériau piézo-électrique 7. L'ensemble est situé au dessus d'une couche 6 réalisant un couplage acoustique, laquelle est disposée sur un résonateur inférieur comportant deux électrodes respectivement inférieure 3 et supérieure 5 venant enserrer une couche de matériau piézo-électrique 4.

De l'autre côté de l'axe vertical, et en parfaite symétrie avec le premier étage, le circuit comporte un second étage qui se compose d'un résonateur supérieur et d'un résonateur inférieur séparé par la couche de couplage acoustique 6. Le résonateur supérieur se compose de deux électrodes inférieure 21 et supérieure 22 enserrant la couche 7. Le résonateur inférieur se compose des deux électrodes 3 et 5 prenant en sandwich la couche 4.

L'ensemble composé des deux étages est disposé sur un miroir acoustique 2, lui-même disposé sur un substrat 1 de silicium ou SiGe comportant éventuellement des circuits logiques et analogiques en technologie MOS ou CMOS.

Cette structure dite CFR est bien connue d'un homme du métier et il n'est pas nécessaire de la décrire plus avant, et notamment son procédé de fabrication.

On rappellera simplement que le résonateur supérieur (électrodes 11 et 12 et la couche 7) reçoit le signal électrique à filtrer et le convertit en une onde acoustique qui est une onde de volume. Cette onde acoustique se transmet du haut vers le bas via le couplage acoustique de la couche 6 jusqu'au résonateur inférieur du premier étage où elle se convertit en un signal électrique transmis alors vers le résonateur inférieur du second étage puisque ce résonateur partage les mêmes électrodes que le résonateur inférieur du premier étage.

L'onde de volume peut alors remonter les couches du second étage et, via le couplage acoustique réalisé par la couche 6, se propager au résonateur supérieur du second étage, situé à droite de la figure.

La figure 2 montre concrètement le chemin parcouru par l'onde de volume au sein des deux structures, respectivement gauche et droite, du circuit CRF, et ce via des couplages successifs, électro-mécanique et également mécanique.

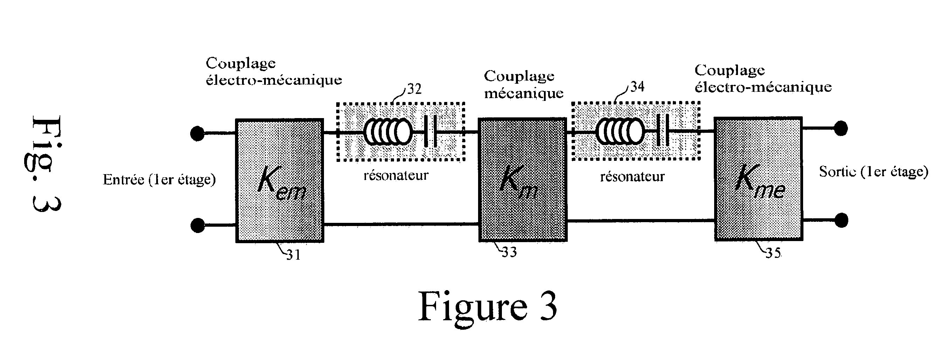

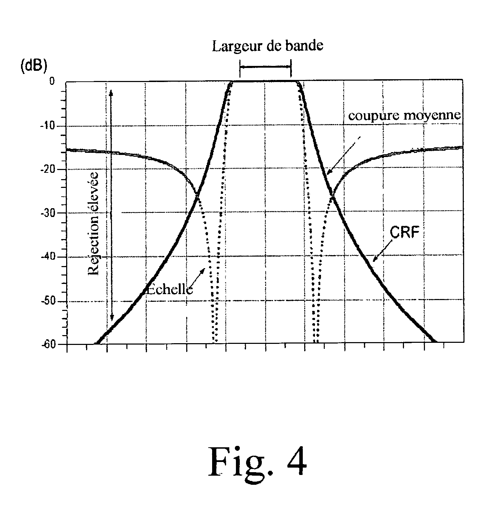

La figure 3 met particulièrement en évidence la chaîne des couplages mise en oeuvre dans le filtre CRF. Les résonateurs supérieurs et inférieurs sont représentés respectivement par les éléments 32 et 34 de la figure 4. On voit que le signal électrique présenté à l'entrée du premier étage subit une conversion électro-mécanique (Kem), se traduisant ainsi par un transfert d'énergie électrique vers une énergie mécanique représentée par un bloc de couplage électro-mécanique Kem 31. L'onde de volume est transmise au résonateur inférieur du premier étage, via la couche 6 qui opère un couplage Km purement mécanique et représenté par le bloc 33. Le résonateur inférieur du premier étage reçoit cette onde et convertit l'énergie mécanique reçue en une énergie électrique se traduisant par un signal électrique aux bornes 3 et 5 du résonateurs inférieur de droite.

Ce signal électrique est alors transmis au résonateur inférieur du second étage puisque ce dernier partage les mêmes électrodes que le résonateur inférieur du premier étage.

La figure 4 illustre plus particulièrement la comparaison de la courbe de filtrage d'un circuit CRF par rapport à un groupement classique de résonateur BAW de type « échelle».

A largeur de bande égale, on constate que le circuit CRF offre un taux de réjection plus élevé que celui d'une structure ECHELLE classique, et ce particulièrement lorsque l'on se situe loin de la bande passante. On obtient ainsi un filtrage efficace sur une large bande de fréquence.

Ce gain de performance du circuit CRF s'obtient parallèlement à une réduction de l'encombrement dans le circuit semi-conducteur puisque la structure CRF permet d'empiler deux résonateurs BAW pour constituer un étage.

Ce circuit peut en outre être facilement combiné avec un autre circuit CFR pour réaliser un circuit de filtrage complexe présentant deux impédances, respectivement d'entrée Zin et de sortie Zout, distinctes. A cet effet, on combine deux circuits CFR en venant connecter les étages d'entrée en parallèle et les étages de sortie en série.

Enfin, le filtre à résonateur couplés facilite la conversion vers une structure différentielle.

En dépit de ces avantages, le circuit CFR présente, outre une difficulté de réalisation supérieure, un grave inconvénient.

On observe en effet que, dans un voisinage proche de la bande passante, le circuit ne présente une sélectivité très moyenne découlant d'une pente bien moins raide que celle qui caractérise la structure ECHELLE. Cet inconvénient est rédhibitoire en téléphonie mobile où l'on constate la présence de bandes de fréquences particulièrement proches qu'il faut savoir filtrer de manière efficace. En particulier, en téléphonie mobile de nouvelle génération, on prévoit d'organiser deux bandes de fréquences assez proche, l'une pour l'émission et l'autre pour la réception et il est clair que pour une telle application, le circuit CRF apparaît peu adapté.

Bien évidemment, on a songé à grouper les structures de filtre CRF parfaitement identiques de manière à augmenter l'ordre du global du filtre passe-bande et, par suite, augmenter la sélectivité au voisinage de la bande. Néanmoins, cette solution conduirait à une augmentation significative de la surface occupée sur le substrat semi-conducteur mais, surtout, conduirait à accroître les pertes au sein du filtre réduisant autant le coefficient de qualité du filtre.

C'est un inconvénient auquel on se propose de remédier.

### Exposé de l'invention

La présente invention a pour but de proposer un circuit de filtre passe bande basé sur des résonateurs acoustiques de type BAW qui sont couplés mécaniquement, offrant une sélectivité améliorée et ce même au voisinage de la bande passante.

Un autre but de la présente invention consiste à proposer un circuit de filtrage passe-bande performant susceptible d'être utilisé pour les applications de téléphonie mobile de dernière génération.

Un troisième but de la présente invention consiste à réaliser un circuit de filtrage passe-bande performant susceptible d'être intégré au sein d'un produit semi-conducteur et limitant l'espace utilisé sur le substrat semi-conducteur.

L'invention réalise ces buts au moyen d'un filtre à résonateur couplés comportant :
- un substrat;
- un miroir acoustique destiné à servir de support à des résonateurs acoustiques , et à isoler ces résonateurs du substrat ;
- une première structure comportant un résonateur supérieur et un résonateur inférieur couplés l'un à l'autre au moyen d'au moins une couche de couplage acoustique;
- une seconde structure comportant un résonateur supérieur et un résonateur inférieur couplés l'un à l'autre au moyen d'au moins une couche de couplage acoustique. Les résonateurs supérieurs de la première et seconde structure servant respectivement d'entrée et de sortie au filtre et les résonateurs inférieurs de la première et seconde structure disposant des mêmes électrodes.

Le filtre est **caractérisé en ce que** les première et seconde structures sont connectées via un cinquième résonateur dont les électrodes et la couche piézo-électriques sont celles desdits résonateurs inférieurs de la dite première et seconde structure.

Dans un mode de réalisation, les première et seconde structure sont parfaitement symétrique par rapport à un axe vertical.

Dans un mode de réalisation, les résonateurs sont des résonateurs de type Bulk Acoustic Wave (B.A.W.) .

De préférence, les résonateurs de type BAW sont réalisés par des techniques de dépôt de couches minces (*thin Film*), de pulvérisation (*sputtering*), d'évaporation sous vide ou de dépôt CVD (*Chemical Vapor Deposition*)*.*

Dans un mode de réalisation, les résonateurs de type BAW comporte un matériau piezo électrique peut être ZnO, ALN, ZnS ou toute céramique ferroélectrique.

Dans un mode de réalisation les résonateurs comportent des électrodes composées de tungstène (W), de l'aluminium (AL), du cuivre (Cu), du molybdène (MO), du nickel (Ni), du titane (Ti), de l'argent (Ag), de l'or (Au) ou du tantale (Ta).
L'invention réalise également un procédé de fabrication d'un circuit de filtrage à résonateurs couplés comportant les étapes suivantes :
- préparer un substrat ;
- disposer un miroir acoustique au dessus du substrat;
- disposer une première et une seconde structure comportant chacune un résonateur inférieur disposant d'une électrode inférieure, une électrode supérieur et une couche piézo-électrique, et disposant en outre d'un résonateur supérieur comportant une électrode inférieure, une électrode supérieure et une couche piézo-électrique ; lesdits résonateurs inférieurs et supérieurs de chacune des structures étant séparés par une couche de couplage acoustique.

Dans l'invention, les première et seconde structure sont espacées de manière suffisance de façon à permettre l'insertion, entre les deux structures, d'un cinquième résonateur de type SMR partageant les électrodes et la couche piézo-électriques desdits résonateurs inférieurs.

### Description des dessins

D'autres caractéristiques, but et avantages de l'invention apparaîtront à la lecture de la description et des dessins ci-après, donnés uniquement à titre d'exemples non limitatifs. Sur les dessins annexés :
La figure 1 rappelle la structure d'un circuit de filtrage de type CRF connu.

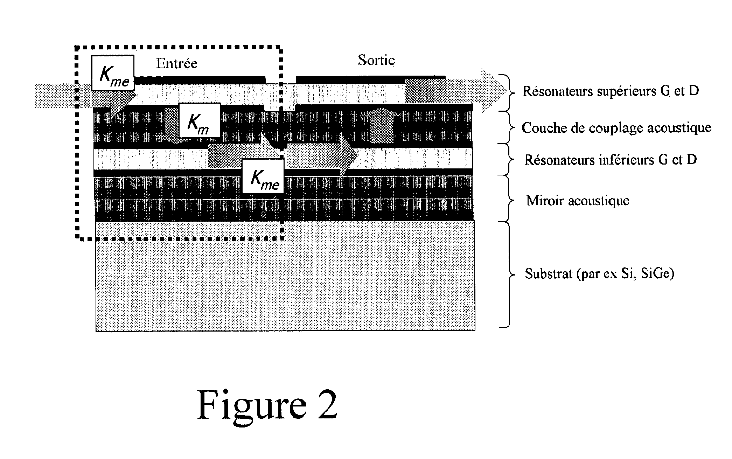

La figure 2 illustre le schéma de parcours de l'onde de volume au sein du circuit CRF connu.
La figure 3 illustre le modèle électrique équivalent du premier étage du circuit connu CRF.
La figure 4 illustre plus particulièrement la comparaison de la courbe de filtrage d'un circuit CRF par rapport à un groupement classique de résonateur BAW de type « échelle ».

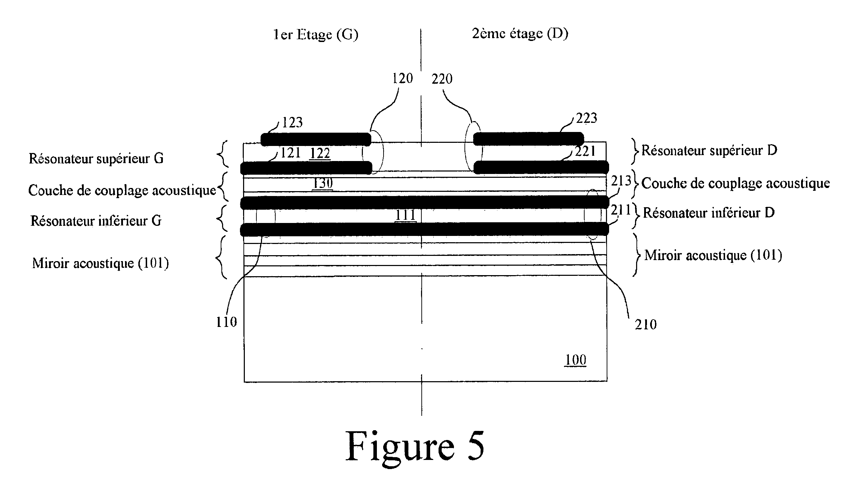

La figure 5 illustre une architecture générale d'un circuit de filtrage CRF adapté pour l'implémentation de la présente invention.

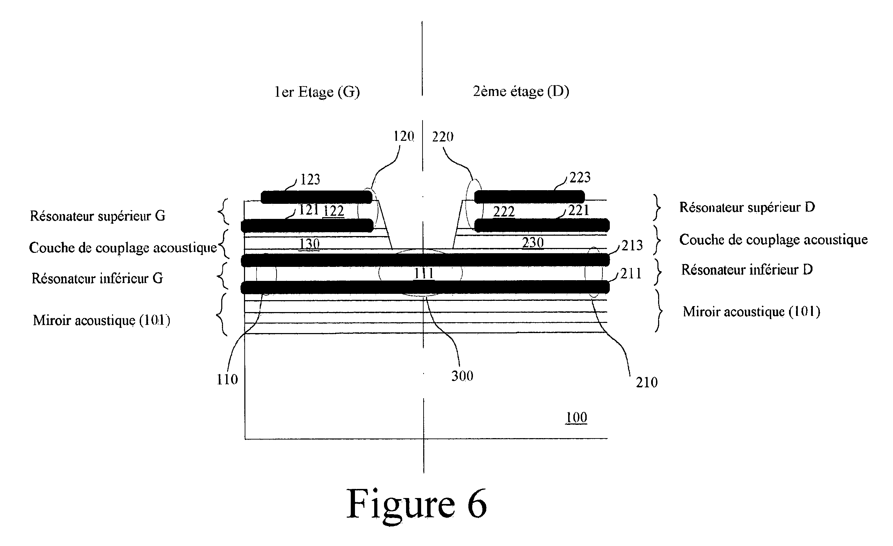

La figure 6 illustre la modification de la structure de la figure 5 afin de réaliser un circuit de filtrage conforme à la présente invention.

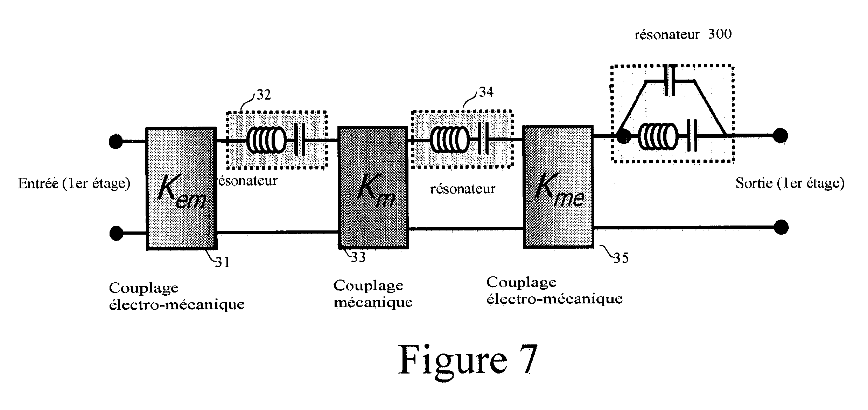

La figure 7 illustre plus particulièrement l'effet de l'évidemment opéré entre les deux structures GAUCHE et DROITE du filtre selon la présente invention.

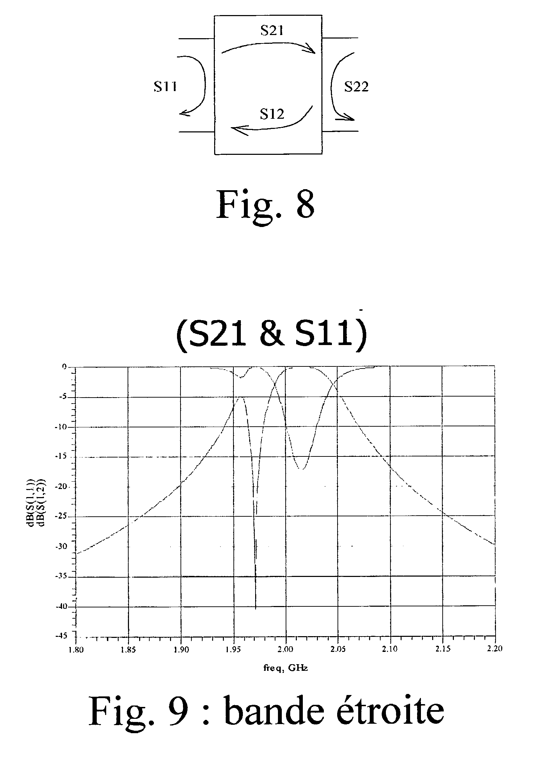

La figure 8 montre le modèle électrique équivalent du circuit de la figure 7, montrant faisant état des coefficients S11, S21, SC

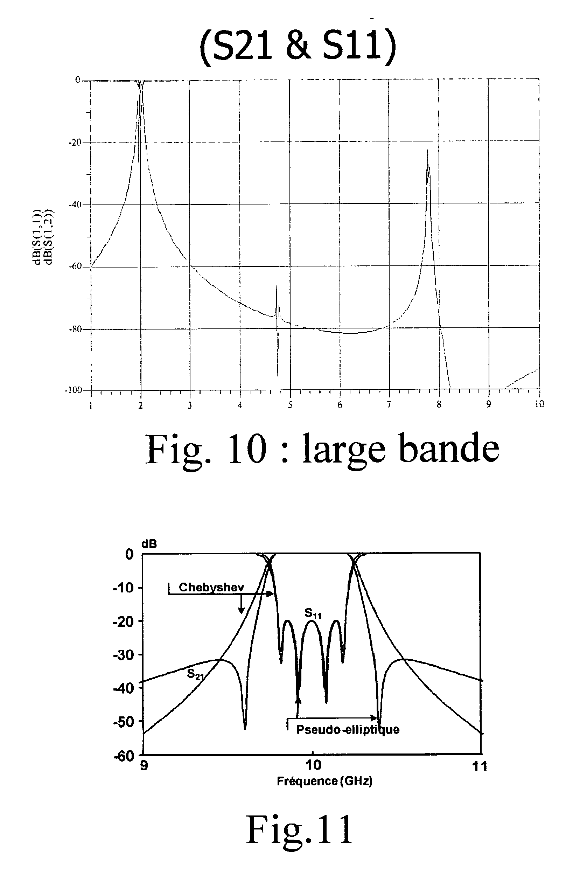

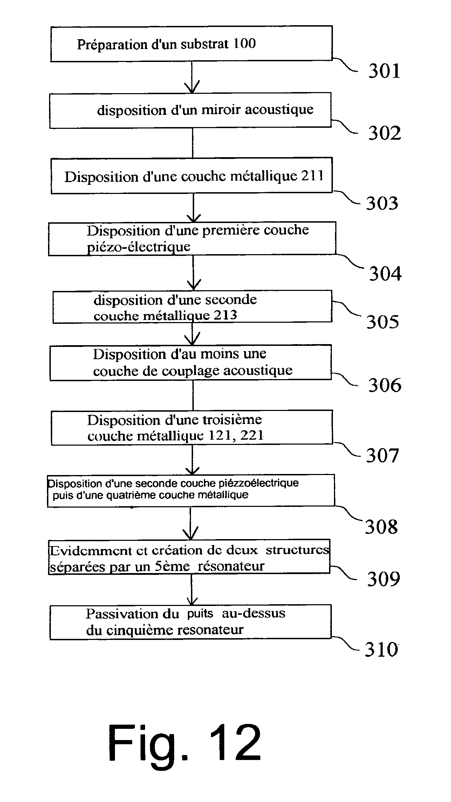

Les figures 9 et 10 illustrent respectivement les courbes de performances, respectivement large bande et bande étroite.
La figure 11 illustre le coefficient S11 de la courbe de performance du circuit de filtrage selon la présente invention.

### Description d'un mode de réalisation préféré

On décrira à présent un mode de réalisation d'un circuit de filtrage comportant des résonateurs couplés particulièrement adapté à la réalisation d'un circuit de filtrage utilisable en téléphonie mobile, et intégrable sur circuit de type *Very Large Scale Integration* (VLSI). En téléphonie mobile, et notamment dans les applications les plus récentes telles que le *Wide Code Division Multiplexing Access* (WCDMA), on rencontre la nécessité d'opérer un filtrage particulièrement performant afin de pouvoir séparer des canaux particulièrement proches. Il est à noter qu'il ne s'agit là que d'un exemple non limitatif d'utilisation du filtre que l'on va décrire ci-après.

En référence à la figure 5, on décrit la réalisation d'un circuit de filtrage à résonateurs couplés conforme à la présente invention.

Le circuit de filtrage se compose d'un substrat de type silicium 100 réalisé en silicium (Si), en arséniure de Gallium (GaAs), en verre ou en céramique. Ce substrat 100 pourra comporter des structures MOS classiques permettant de réaliser des circuits logiques et/ou analogiques qui ne font pas partie de la présente invention et qui ne seront pas décrits plus avant.

Le circuit de filtrage comporte ensuite, situé au-dessus du substrat 100, un miroir réfléchissant 101 - ou miroir de BRAGG - qui se compose d'un empilement de couches présentant des propriétés acoustiques et des constantes diélectriques différentes, disposé sur le substrat 100. Le miroir réfléchissant assure une déperdition minimale des ondes acoustiques au sein du substrat 100.

Le circuit de filtrage comporte en outre, au-dessus du miroir acoustique, un ensemble de quatre résonateurs de type BAW se départageant en deux structures, respectivement GAUCHE et DROITE, parfaitement symétriques par rapport à un axe vertical passant par le milieu de la figure.

Les deux structures sont en tout point semblables aux deux structures connues dans un filtre à résonateur couplés CRF classique, à l'exception toutefois d'un aménagement spécifique des structures gauche et droite de manière à les espacer suffisamment pour pouvoir y insérer un cinquième résonateur 300 illustré plus particulièrement dans la figure 6.

Les deux structures, respectivement GAUCHE et DROITE, comportent chacune un empilement de deux résonateurs, respectivement inférieur et supérieur séparés par une couche de couplage acoustique 130, elle-même pouvant se diviser en sous-couches de couplage, le cas échéant.

Les résonateurs sont des résonateurs acoustiques de type Bulk Acoustic Wave (B.A.W.) que l'on réalise au moyen de techniques connues de dépôt de couches minces (*thin Film*) au moyen de techniques de pulvérisation (*sputtering*), d'évaporation sous vide ou de dépôt CVD (*Chemical Vapor Deposition*) bien connues. Chaque résonateur se compose d'une couche de matériau piezo électrique présentant des caractéristiques acoustiques, de deux électrodes respectivement inférieure et supérieure enserrant cette couche. Le matériau piezzo électrique peut être ZnO, ALN, ZnS ou toute céramique ferroélectrique connue d'un homme du métier. Les électrodes peuvent être réalisées métal quelconque adapté à l'application recherchée, tel que, par exemple, du tungstène (W), de l'aluminium (AL), du cuivre (Cu), du molybdène (MO), du nickel (Ni), du titane (Ti), de l'argent (Ag), de l'or (Au) ou du tantale (Ta).

Comme on le voit sur la figure 5, la structure de GAUCHE (resp. DROITE) comporte un résonateur inférieur 110 (resp. 210) comportant une électrode inférieure 211 et une électrode supérieure 213 enserrant une couche de matériau piézo-électrique 111.

La structure de GAUCHE (resp. DROITE) comporte en outre un résonateur supérieur 120 (resp. 220) comportant une électrode inférieure 121 (resp. 221) et une électrode supérieure 123 (resp. 223) enserrant une couche de matériau piézo-électrique 122.

Ainsi, le filtre à résonateurs couplés se présente sous une forme similaire à celle des filtres CRF, si ce n'est que les électrodes 211 et 213 prenant en sandwich le matériau 111 présente une dimension suffisante pour bien espacer les deux structures respectivement gauche et droite.

Il est à noter que les étapes de fabrication des éléments qui sont illustrés dans la figure 5 sont similaires au procédé utilisé pour un filtre CRF classique et ne seront par conséquent pas décrit plus en détail.

On décrit à présent, en relation avec la figure 6 la partie spécifique distinguant plus particulièrement le circuit de filtrage à résonateurs couplés des circuits CRF connus.

L'espace aménagé entre les structures GAUCHE et DROITE situées de part et d'autre de l'axe de symétrie vertical, fait l'objet d'un évidemment spécifique destiné à venir retirer la couche piézo-électrique 122, mais également la plus grande partie de la couche de couplage acoustique 130, comme cela est visible sur la figure. On opère à cet effet par des techniques de gravure connues, sèche ou humide.

Cette opération de gravure réalisée dans la partie centrale du circuit de filtrage a pour effet de désolidariser la partie supérieures des deux structures GAUCHE et DROITE. On comble ensuite l'évidemment par une couche de passivation, telle que du SiO₂ par exemple.

La structure DROITE comporte ainsi une couche de couplage acoustique 230 distincte de la couche de couplage acoustique originelle 130.

De même le résonateur supérieur de la structure DROITE comporte une couche piézo-électrique 222 qui est à présent distincte de la couche piézo-électrique 122 originelle.

L'évidemment ainsi réalisé a pour effet de faire apparaître un cinquième résonateur 300 de type SMR (*Surface Mounted Resonator*) comportant les électrodes 211 et 213 et venant enserrant la couche piézo-électrique 111.

Ce cinquième résonateur BAW présentent lui également deux fréquences de résonance qui sont caractéristiques de la nature du matériau piezzo électrique utilisé (ZnO, ALN, ZnS ou toute céramique ferroélectrique connue d'un homme du métier), mettant en évidence deux pulsations de résonance, respectivement série (ω*s* correspondant à une impédance minimale) et parallèle (ω*p* correspondant à une impédance maximale). Hors le voisinage des deux pulsations de résonance, le résonateur se comporte de manière capacitive

Les valeurs des pulsations ω*s* et ω*p* dépendent de l'épaisseur du matériau piézo-électrique et l'écart entre ces deux valeurs résulte du coefficient de couplage électromécanique.

Ce cinquième résonateur 300, ainsi réalisé très simplement à partir de la structure originelle du filtre à résonateurs couplés, permet le positionnement d'un zéro de transmission au sein de la courbe de fréquence et, ainsi, d'accroître de manière significative la pente de la réponse en fréquence du filtre dans le voisinage de la bande passante qui, comme on l'avait vu, était traité de manière non satisfaisante dans le fitre CRF classique.

La figure 7 illustre plus particulièrement l'effet de l'évidemment opéré entre les deux structures GAUCHE et DROITE du filtre selon la présente invention. Les éléments inchangés par rapport à la figure 3 conservent les mêmes numéros de référence. On voit que vient s'intercaler au niveau de la sortie du premier étage le résonateur 300 présentant les deux fréquences de résonance et d'antirésonnance.

La figure 8 rappelle la définition des coefficients S11, S21, S12 et S22 du quadripôle caractéristique du modèle équivalent du circuit de filtrage. Comme cela est connu d'un homme de métier, le coefficient S11 est caractéristiques des pertes par réflexion au sein du filtre tandis que le coefficient S21 caractérise l'énergie transférée par le quadripôle.

La figure 9 illustre la modification de la courbe de filtrage due à la présence du cinquième résonateur 300 dans la bande étroite au voisinage de la passante.

La figure 10 illustre la modification de la courbe de filtrage due à la présence du cinquième résonateur 300 dans la bande large s'éloignant de manière significative de la bande passante.

La figure 11 illustre les courbes représentatives des facteurs S11 et S21 du circuit selon la présente invention.

On décrit à présent le procédé de fabrication d'un circuit de filtrage conforme à la présente invention.

L'invention permet la réalisation d'un filtre à résonateurs couplés performant au moyen d'un procédé qui se base pour une large part sur le procédé existant d'un filtre CRF connu.

### A cet effet, le procédé comporte les étapes suivantes:

Dans une étape 301, on prépare un substrat 100 destiné à recevoir les structures de résonateurs. Eventuellement, le substrat pourra être préparé pour recevoir d'autres structures de type MOS bien connues d'un homme du métier.

Dans une étape 302, on dispose un miroir acoustique 101 au dessus du substrat, suivant des méthodes connues.
Dans une étape 303, on dispose une première couche métallique 211 qui sera destinée à former l'électrode inférieure des résonateurs inférieurs.

Dans une étape 304, on dispose une première couche piézo-électrique 111;

Dans une étape 305, on dispose une seconde couche métallique 213 destiné à compléter la structure des résonateurs inférieurs 110 et 210.

Dans une étape 306 , on dispose d'une ou plusieurs couches de matériaux de couplage acoustique 130.

Dans une étape 307, on dispose une troisième couche métallique destinée à former l'électrode inférieure (121, 221) des résonateurs supérieurs 120 et 220.

Dans une étape 308, on dispose une seconde couche piézo-électrique 122;

Dans une étape 309, on procède à un évidemment de la partie centrale de manière à faire apparaître deux structures comportant chacune sa propre couche de couplage acoustique composée d'une partie desdites une ou plusieurs couches de matériaux de couplage acoustique.

Plus particulièrement, chaque structure (resp. GAUCHE, DROITE) comporte sa propre électrode inférieure (resp. 121, 221) et une électrode supérieure (resp. 123, 223) et une couche de matériau piézo-électrique (resp. 122, 222).

On complète l'opération par une phase de passivation pour venir obturer le puits ainsi réalisé.

Les deux structures sont alors connectées l'une à l'autre par le cinquième résonateur 300 dont les électrodes (211, 213) et la couche piézo-électrique (111) sont celles desdits résonateurs inférieurs de la dite première et seconde structure.

L'invention trouve avantageusement application en téléphonie mobile, notamment dans la réalisation de filtres passe-bande destinés à discriminer de manière précise deux bandes de fréquences particulièrement proche.

## Revendications

1. Filtre à résonateur couplés comportant :
- un substrat (100) ;
- un miroir acoustique (101) destiné à servir de support à des résonateurs acoustiques , et à isoler ces résonateurs du substrat ;
- une première structure (GAUCHE) comportant un résonateur supérieur (120) et un résonateur inférieur (110) couplés l'un à l'autre au moyen d'au moins une couche de couplage acoustique (130) ;
- une seconde structure (DROITE) comportant un résonateur supérieur (220) et un résonateur inférieur (210) couplés l'un à l'autre au moyen d'au moins une couche de couplage acoustique (130) ;
- Lesdits résonateurs supérieurs de la première et seconde structure servant respectivement d'entrée et de sortie au filtre et les résonateurs inférieurs de la première et seconde structure disposant des mêmes électrodes (211, 213) ;
**caractérisé en ce que** les dits résonateurs inférieurs des dites premières et deuxième structures sont espacées d'une manière suffisante pour permettre le logement d'un cinquième résonateur (300), et que les dites première et seconde structures sont connectées via ledit cinquième résonateur (300) dont les électrodes et la couche piézo-électriques sont celles desdits résonateurs inférieurs de la dite première et seconde structure.

2. Filtre selon la revendication 1 **caractérisé en ce que** lesdites première et seconde structure sont symétrique par rapport à un axe vertical passant par ledit cinquième résonateur (300).

3. Filtre selon la revendication 1 ou 2 **caractérisé en ce que** les résonateurs sont des résonateurs de type Bulk Acoustic Wave (B.A.W.).

4. Filtre selon la revendication 3 **caractérisé en ce que** lesdites résonateurs de type BAW sont réalisés par des techniques de dépôt de couches minces (*thin Film*), de pulvérisation (*sputtering*), d'évaporation sous vide ou de dépôt CVD (*Chemical Vapor Deposition*).

5. Filtre selon l'une quelconque des revendications 1 à 4 **caractérisé en ce que** les résonateurs de type BAW comporte un matériau piezo électrique peut être ZnO, ALN, ZnS ou toute céramique ferroélectrique.

6. Filtre selon l'une quelconque des revendications 1 à 5 **caractérisée en ce que** les résonateurs comportent des électrodes composées de tungstène (W), de l'aluminium (AL), du cuivre (Cu), du molybdène (MO), du nickel (Ni), du titane (Ti), de l'argent (Ag), de l'or (Au) ou du tantale (Ta).

7. Filtre selon l'une quelconque des revendication précédentes **caractérisé en ce qu'**il est destiné à la réalisation d'un circuit de réception pour téléphonie mobile.

8. Procédé de fabrication d'un circuit de filtrage à résonateurs couplés comportant les étapes suivants :
- founir un substrat (100);
- disposer un miroir acoustique (101) au dessus du substrat;
- disposer une première (GAUCHE) et une seconde (DROITE) structure comportant chacune un résonateur inférieur (110, 210) disposant d'électrodes et d'une couche piézo-électrique et un résonateur supérieur (120, 220), lesdits résonateurs inférieurs et supérieurs étant séparés par une couche de couplage acoustique (130), lesdites première et seconde structure étant espacées de manière à permettre l'insertion, entre les deux, d'un cinquième résonateur (300) partageant les électrodes et la couche piézo-électriques desdits résonateurs inférieurs.

9. Procédé de fabrication selon la revendication 8 **caractérisé en ce qu'**il comporte:
- disposition d'un substrat (100) ;
- disposition d'un miroir acoustique (101) au-dessus du substrat;
- disposition d'une première couche métallique (211);
- disposition d'une première couche piézo-électrique (111);
- disposition d'une seconde couche métallique (213) ;
- disposition d'une ou plusieurs couches de matériaux de couplage acoustique (130), ladite couche assurant la transmission d'ondes acoustiques de volume;
- disposition d'une troisième couche métallique (121, 221) ;
- disposition d'une seconde couche piézo-électrique (122, 222);
- disposition d'une quatrième couche métallique (123 , 223) ;
- évidemment par gravure destiné à faire apparaître deux structures distinctes comportant chacune :
- sa propre couche de couplage acoustique composée d'une partie desdites une ou plusieurs couches de matériaux de couplage acoustique (130) ;
- un résonateur supérieur comportant une électrode inférieure (resp. 121, 221) et une électrode supérieure (resp. 123, 223) et une couche de matériau piézo-électrique (resp. 122, 222) ;
lesdits résonateurs inférieurs des dites premières et deuxième structures sont espacées d'une manière suffisante pour permettre le logement d'un cinquième résonateur (300), et lesdites structures étant connectées l'une à l'autre par un cinquième résonateur (300) dont les électrodes (211, 213) et la couche piézo-électrique (111) sont celles desdits résonateurs inférieurs de la dite première et seconde structure.

10. Procédé selon la revendication 9 **caractérisé en ce que** les résonateurs de type BAW comporte un matériau piézo-électrique peut être ZnO, ALN, ZnS ou toute céramique ferroélectrique.
